Europäisches Patentamt

European Patent Office

Office européen des brevets

(11) Publication number: **0 497 011 A1**

# EUROPEAN PATENT APPLICATION

(21) Application number: **91200170.8**

(22) Date of filing: **29.01.91**

(51) Int. Cl.5: **G02B 6/28**, G02B 6/42, G02B 6/38, G02B 6/36, H05K 7/00

Amended claims in accordance with Rule 86 (2) EPC.

(43) Date of publication of application: **05.08.92 Bulletin 92/32**

(84) Designated Contracting States: **BE DE ES FR GB IT NL SE**

(71) Applicant: **BELL TELEPHONE MANUFACTURING COMPANY Naamloze Vennootschap**
**Francis Wellesplein 1**
**B-2018 Antwerp(BE)**

(72) Inventor: **Delbare, Wim Jozef Robert**
**Heiveldstraat 153**
**B-9040 Gent-St. Amandsberg(BE)**
Inventor: **Vandewege, Jan Alfons Oda**
**Geelgorsstraat 19**
**B-9032 Wondelgem(BE)**

(74) Representative: **Vermeersch, Robert et al**
**BELL TELEPHONE MANUFACTURING COMPANY Naamloze Vennootschap Patent Department Francis Wellesplein 1**
**B-2018 Antwerpen(BE)**

(54) **Circuit board assembly.**

(57) This assembly includes a circuit board (1) with an embedded optical fiber (4) having a local deformation (6) defined by a crossing wire (7). This local deformation (6) comprises two bent fiber parts (9, 10) having a common or individual optical tap (8) at the external surface (5) of the circuit board so that this tap may be coupled to an input/output device (11).

Fig. 1

Rank Xerox (UK) Business Services

The present invention relates to a circuit board assembly including at least one circuit board with at least one embedded optical waveguide able to be coupled to an optical input/output device.

Such a circuit board assembly is generally known in the art. It would be possible to make the optical waveguide accessible through a recess in the circuit board and to mount the input/output device, e.g. an electro-optical transducer, in this recess together with an adjustment member allowing the transducer to be accurately aligned with the waveguide. However, such a solution is not fully satisfactory because the generally small dimensions of the recess do not allow the required alignment to be performed in an easy way.

An object of the present invention is to provide a circuit board assembly of the above type, but which allows the alignment of the waveguide and the input/output device to be realized in an easier way.

According to the invention this object is achieved due to the fact that said optical waveguide has at least one locally bent part which at least reaches an upper/lower external surface of said circuit board.

The optical waveguide may thus be aligned with an optical input/output device which is external to the circuit board and this is a relatively easy operation.

The present invention also relates to a circuit board assembly with at least one circuit board with a least one embedded optical waveguide. This circuit board assembly is characterized in that said optical waveguide is embedded in a flexible layer having at least one adjacent rigid layer as well as an end extending beyond the edges of said rigid layer.

The flexible end thus allows the optical waveguide embedded in the circuit board to be optically coupled with another optical waveguide even when the latter is disposed at an angle with respect to this circuit board.

The above mentioned and other objects and features of the invention will become more apparent and the invention itself will be best understood by referring to the following description of embodiments taken in conjunction with the accompanying drawings wherein:

Fig. 1 represents a cross section of an embodiment of a circuit board assembly 1 according to the invention together with an optical waveguide 11 coupled to this board;

Fig. 2 shows the circuit board assembly 1 of Fig. 1 prior to the execution of a last manufacturing step;

Figs. 3 to 5 represent cross sections of various other embodiments of a circuit board assembly 1 according to the invention;

Fig. 6 is a cross-section of a further embodiment of a circuit board assembly according to the invention;

Fig. 7 is a top view of a still further embodiment of a circuit board assembly according to the invention;

Fig. 8 is a cross-section, on an enlarged scale, along line VIII-VIII of Fig. 7.

In these figures similar elements are indicated by the same reference number.

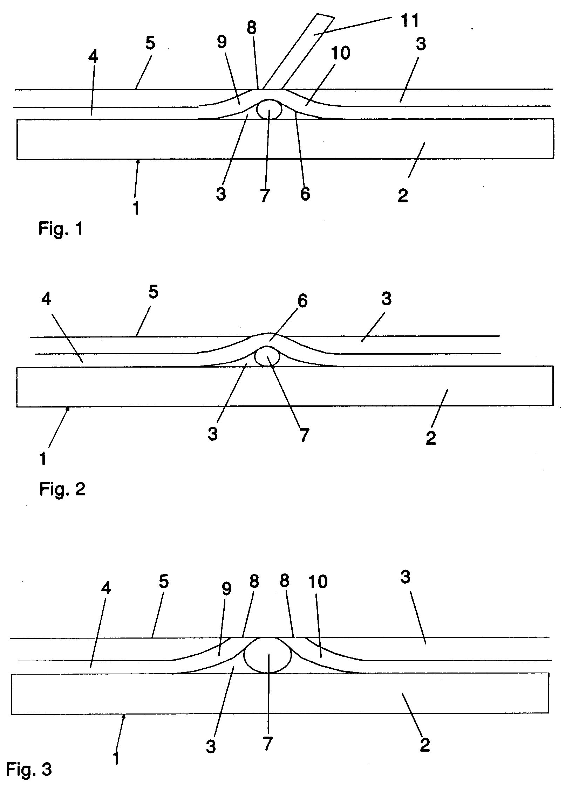

The circuit board assembly which is generally indicated by reference numeral 1 in Fig. 1 comprises a lower layer 2 and an upper layer 3 which are both made of an epoxy, as well as an optical fiber 4 embedded in the upper layer 3 which has an upper surface 5. The optical fiber 4 is lengthwise supported by the lower layer 2 over the major part of its length except for a portion 6 which is locally deformed and partly rests on a transverse carrier constituted by a wire 7 also supported by the lower layer 2 and crossing the fiber 4 at a right angle. The locally deformed portion 6 comprises two parts 9 and 10 which are bent in the direction of the upper surface 5 and reach this surface 5 where they have a common exposed surface or optical tap 8. They both form part of the same uninterrupted fiber 4.

Prior to the execution of a last manufacturing step to obtain the assembly of Fig. 1, and as shown in Fig. 2, the locally deformed portion 6 protrudes beyond the upper surface 5 of the layer 3 over a distance preferably smaller than the thickness of the cladding and coating layers of the fiber 4. As a consequence, when during this last step the locally deformed portion is ground off until it is level with the upper surface 5 of the layer 3 the optical fiber 4 is not interrupted so that light is still able to pass through it, but an optical tap 8 (Fig. 1) is formed at the upper surface 5. This optical tap 8 may be optically coupled with an input/output device such as an electro-optical transducer (not shown) or with an optical waveguide 11 to extract light from or inject light into the embedded fiber 4.

In the embodiment of Fig. 3 the transverse crossing wire 7 locally carrying the optical fiber 4 has a diameter such that prior to the last manufacturing step of the assembly the local deformation 6 protrudes beyond the upper surface 5 of the layer 3 over a distance preferably larger than the diameter of the fiber 4. As a consequence, when during the last manufacturing step this locally deformed portion is ground off until it is level with the upper surface 5 the optical fiber 4 is interrupted so that light is no longer able to pass through it and that two distinct bent parts 9 and 10 are obtained, each with a distinct optical tap 8 at the exposed surface 5. These optical taps 8 may each be coupled with an input/output device.

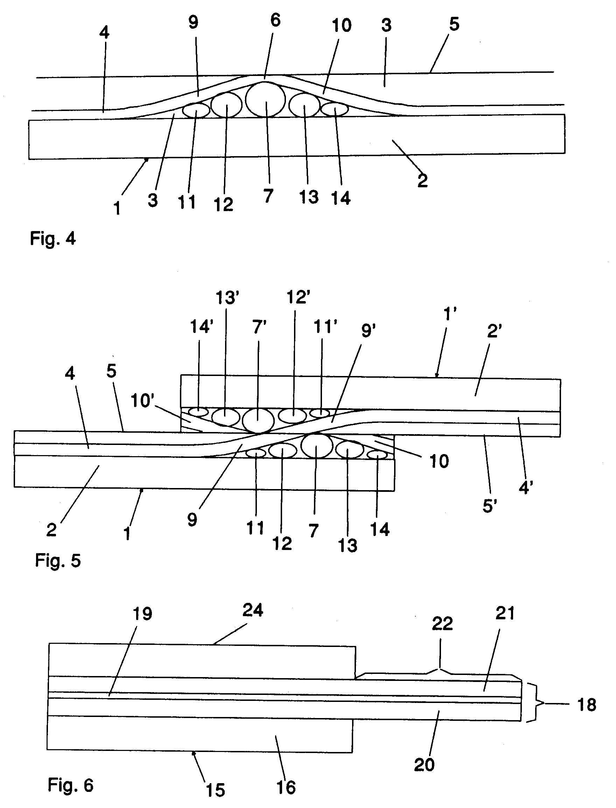

In the embodiments of Figs. 1 and 3 the slope of each of the bent parts 9, 10 with respect to the layer 2 or the general plane of the circuit board 1 may be relatively large, especially when the diameter of the single crossing wire 7 is relatively large as shown in Fig. 3. In that case some danger of breaking the optical fiber 4 during its local deformation exists. To avoid this, and as represented in Fig. 4, the circuit board assembly 1 shown therein comprises an optical fiber 4 which is supported by a carrier constituted by a plurality of juxtaposed parallel crossing wires 11, 12, 7, 13 and 14, the diameter of the wires 12, 13 being comprised between those of 11, 14 and 7. Thus the slope of the locally bent portions 9 and 10 is less pronounced than in Figs. 1 and 3, thereby avoiding breaking of the fiber. The same result can be obtained by using juxtaposed parallel crossing wires with increasing and decreasing hardnesses or by combining the two techniques, i.e. by using crossing wires with increasing and decreasing hardnesses and diameters.

It has to be noted that the above technique, instead of being applied to circuit board assemblies with rigid layers 2 and 3, is also applicable in case these layers are flexible and to flexible ribbon cables containing optical conductors. The crossing wires may be optical fibers but also wires of copper or any other material may be used and the local deformation may for instance also be obtained by leading the fiber over a transverse carrier of any other type than a wire.

The circuit board assembly of Fig. 5 is an optical connector constituted by the combination of two like circuit board assemblies 1 and 1' each obtained by applying the teachings of Figs. 3 and 4. Indeed, in each of 1 and 1' the optical fiber 4, 4' is supported by a plurality of juxtaposed parallel crossing wires 11, 12, 7, 13, 14; 11', 12', 7', 13', 14' having increasing/decreasing diameters and the diameters of these crossing wires are such that after grinding of the deformed portion of the optical fiber 4; 4' protruding beyond the surface 5; 5' this fiber is interrupted. The optical taps of the bent portions 9 and 9' thus realized in the circuit boards 1 and 1' are aligned and the boards are kept together by mechanical means (not shown).

Due to the fact that the above mentioned grinding operation performed during the last manufacturing step of each of the circuit boards 1 and 1' is not perfect an airgap might exist between the bent optical fiber part 9 and 9' int he connector of Fig. 5 and cause unwanted light reflections. To reduce such reflections it may therefore be useful to interpose between these two optical fiber parts 9 and 9' a transparent elastic film having substantially the same refraction index as the optical fiber parts.

Reference is now made to Fig. 6 which shows a circuit board assembly 15 comprising a bottom layer 16 and a top layer 17 both made of an epoxy as well as a flexible middle layer 18 which comprises optical fibers 19 glued in between two PYRALUX (a Registered Trademark of the Du Pont Company) flexible laminate sublayers 20 and 21. The latter sublayers 20 and 21 are fixed to the lower and upper layers 16 and 17 respectively. Part 22 of the flexible layer extends beyond the layers 16 and 17 and forms a kind of ribbon cable which is integrated in the board. Thus the optical fibers, such as 19, integrated in this circuit board may be easily connected to optical fibers integrated in a backpanel making a substantially right angle with the circuit board by using a connector based on the teachings of Fig. 5 For interconnecting circuit boards located at a relatively large distance use can be made of a flexible ribbon cable, already mentioned above, in which use is made of the technique described in relation to Figs. 1 to 6. For instance, by using a ribbon cable with a plurality of optical taps made according to the technique of Fig. 1 light can be injected in or tapped from several locations along this cable. Also, by using the technique illustrated in Fig. 5 an optical connection can be made between a ribbon cable and a flexible extension, such as 22, of a board or between a ribbon cable and a rigid board.

From the above it follows that the described teachings are applicable to rigid and flexible circuit boards as well as to ribbon cables which may in fact be considered as long and narrow flexible boards. For this reason the term circuit board used in the claims is intended to cover both circuit boards and cables.

Instead of being located between the sublayers 16 and 17 of the circuit board 15 the flexible layer 18 could also be an external layer of this board. Also, instead of being fixed to the layers 16 and 17 the flexible layer 18 of the circuit board assembly 15 may be made detachable from these sublayers, at least locally.

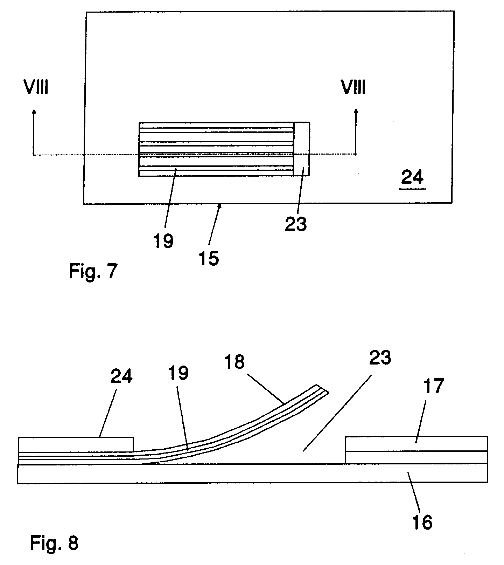

A top view of such a circuit board assembly 15, but having a rectangular opening 23 in the upper layer 17 at the location where the flexible layer 18 is locally detachable is shown in Figs. 7 and 8. The flexible layer 18 visible through the opening 23 and a portion of it may thus be detached from the bottom layer 16 and bent out of the board 15 beyond the upper surface 24 thereof, e.g. to be connected to an optical input/output device.

It has to be noted that all circuit board assemblies described above may have electrical wires embedded in a way similar to the optical fibers so that electrical taps may be realised in the same way as optical taps by local deformations and/or the electrical wires can be brought outside the circuit board embedded in a flexible layer together with the optical fibers.

While the principles of the invention have been described above in connection with specific apparatus, it is to be clearly understood that this description is made only by way of example and not as a limitation on the scope of the invention.

**Claims**

1. Circuit board assembly (1, 15) including at least one circuit board (1) with at least one embedded optical waveguide (4) able to be coupled to an optical input/output device (11), characterized in that said optical waveguide (4) has at least one locally bent part (9, 10) which at least reaches an upper/lower external surface (5; 24) of said circuit board (1; 15).

2. Circuit board assembly according to claim 1, characterized in that said optical waveguide is an optical fiber (4) so that said locally bent optical waveguide part is a locally bent optical fiber part.

3. Circuit board assembly according to claim 2, characterized in that said locally bent optical fiber part (9, 10) has an optical tap (8) at said external surface (5).

4. Circuit board assembly according to claim 2, characterized in that said fiber (4) extends in lengthwise direction parallel to the general plane of said circuit board (1) and is crossed by a carrier means (7; 7, 11/14) which at least partly supports said locally bent optical fiber part (9, 10) and thereby defines the slope between said bent part and said general plane.

5. Circuit board assembly according to claim 4, characterized in that said carrier means is constituted by at least one wire (7).

6. Circuit board assembly according to claim 4, characterized in that said carrier means is constituted by a plurality of juxtaposed wires (11, 12, 7; 7, 13, 14) with different thicknesses.

7. Circuit board assembly according to claim 4, characterized in that said carrier means is constituted by a plurality of juxtaposed wires (11, 12, 7; 7, 13, 14) with different hardnesses.

8. Circuit board assembly according to claim 3, characterized in that said board (1) includes two bent fiber parts (9, 10) forming part of an uninterrupted same optical fiber (4) and having a common optical tap (8).

9. Circuit board assembly according to claim 3, characterized in that said board (1) includes two said bent optical fiber parts (9, 10) forming part of an interrupted same optical fiber (4) and having distinct optical taps (8).

10. Circuit board assembly according to claim 8 or 9, characterized in that said two bent parts (9, 10) belong to a same local deformation (6) of said same optical fiber (4).

11. Circuit board assembly according to claim 9, characterized in that it includes a first (1) and a second (1') of said circuit boards which are so assembled that a bent optical fiber part (9) of said first board (1) is optically coupled with a bent optical fiber part (9') of said second board (1').

12. Circuit board assembly according to claim 11, characterized in that it further includes a transparent elastic film interposed between said optically coupled optical fiber parts (9, 9') and having a refraction index substantially equal to that of said optical fiber parts.

13. Circuit board assembly according to claim 1, characterized in that said locally bent part is constituted by a portion of a detachable flexible layer (18) wherein said optical waveguide (4) is embedded, said portion being detached from an adjacent layer (16).

14. Circuit board assembly according to claim 12, characterized in that said flexible layer portion extends through an opening (23) in another adjacent layer (17).

15. Circuit board assembly including at least one circuit board (15) with at least one embedded optical waveguide (19), characterized in that said optical waveguide (19) is embedded in a flexible layer having at least one (16, 17) adjacent rigid layer as well as an end (22) extending beyond the edges of said rigid layer.

**Amended claims in accordance with Rule 86-(2) EPC.**

1. Circuit board assembly including at least one circuit board (1) with at least one embedded optical waveguide (4) which has at least one locally bent part (5) reaching at least an upper/lower external surface of said circuit board (1) to enable its coupling to an optical input/output device, characterized in that said waveguide (4) forms part of a detachable flexible layer (5) a portion of which comprises said bent part and is detached from an adjacent layer (2).

2. Circuit board assembly according to claim 1, characterized in that said flexible layer portion (5) extends through an opening (8) in another adjacent layer (3).

3. Circuit board assembly including at least one circuit board (1) with at least one embedded optical waveguide (4), characterized in that said optical waveguide (4) is embedded in a flexible layer (5) having at least one adjacent rigid layer (2, 3) as well as an end (10) extending beyond the edges of said rigid layer.

Fig. 1

Fig. 2

Fig. 3

Fig. 4

Fig. 5

Fig. 6

VIII

VIII

24

19

15

23

Fig. 7

24

19

18

23

17

16

Fig. 8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-3 872 236  (R.Ch. SWENGEL, Sr. et al.) <br> * Figures 1-3,5,21-24; column 11, lines 24-46; abstract * | 1 | G 02 B    6/28 <br> G 02 B    6/42 <br> G 02 B    6/38 <br> G 02 B    6/36 <br> H 05 K    7/00 |
| A | --- | 2,9,10 | |
| A | EP-A-0 166 550  (IMPERIAL CHEMICAL IND.) <br> * Figures 1-4; page 7, lines 30-32; page 8, lines 1-24 * <br> --- | 1-5 | |
| A | PATENT ABSTRACTS OF JAPAN, vol. 3, no. 36 (E-100), 27th March 1979; & JP-A-54 13 347 (MATSUSHITA) 31-01-1979 <br> * Whole document * <br> --- | 1,2,3, 11,12 | |
| A | PATENT ABSTRACTS OF JAPAN, vol. 8, no. 248 (P-313)[1685], 14th November 1984; & JP-A-59 121 008 (TOUKIYOU KOGYO DAIGAKU) 12-07-1984 <br> * Whole document * <br> ----- | 1 | |

TECHNICAL FIELDS
SEARCHED (Int. Cl.5)

G 02 B    6/00
H 05 K    7/00

The present search report has been drawn up for all claims

| Place of search | Date of completion of the search | Examiner |
|---|---|---|
| THE HAGUE | 10-10-1991 | MATHYSSEK K. |

EPO FORM 1503 03.82 (P0401)